# FASCICULE DE BREVET EUROPEEN

(11) **EP 3 059 602 B1**
(45) Date de publication et mention de la délivrance du brevet: **21.07.2021**
(21) Numéro de dépôt: 16155803.6
(22) Date de dépôt: 16.02.2016
(51) Int. Cl.: G01R 33/30, G01R 33/31, G01R 33/34, G01N 24/08

(54) **PROCÉDÉ ET DISPOSITIF DE CONTRÔLE DE LA TEMPÉRATURE D'UN FLUX DE FLUIDE DESTINÉ À ÊTRE UTILISÉ PAR UNE SONDE D'ANALYSE PAR RMN, SYSTÈME D'ANALYSE RMN CORRESPONDANT**
VERFAHREN UND VORRICHTUNG ZUR TEMPERATURKONTROLLE EINES FLUIDFLUSSES, DER ZUR VERWENDUNG DURCH EINE NMR-ANALYSESONDE BESTIMMT IST, UND ENTSPRECHENDES NMR-ANALYSESYSTEM
METHOD AND DEVICE FOR MONITORING THE TEMPERATURE OF A STREAM OF FLUID INTENDED FOR BEING USED BY AN NMR ANALYSIS PROBE, CORRESPONDING NMR ANALYSIS SYSTEM

(30) Priorité: 19.02.2015 FR 1551384
(43) Date de publication de la demande: 24.08.2016
(73) Titulaire: COMMISSARIAT À L'ÉNERGIE ATOMIQUE ET AUX ÉNERGIES ALTERNATIVES, 75015 Paris (FR)
(72) Inventeur: BOULEAU, Eric, 38360 SASSENAGE (FR); SAINT-BONNET, Pierre, 38140 LA MURETTE (FR)
(74) Mandataire: Novaimo

(56) Documents cités:
- FR-A1- 2 983 959
- US-A1- 2010 321 018
- US-B1- 7 288 939
- MARTIN R W ET AL: "Variable temperature system using vortex tube cooling and fiber optic temperature measurement for low temperature magic angle spinning NMR", JOURNAL OF MAGNETIC RESONANCE, ACADEMIC PRESS, ORLANDO, FL, US, vol. 168, no. 2, 27 mars 2004 (2004-03-27) , pages 202-209, XP004508572, ISSN: 1090-7807, DOI: 10.1016/J.JMR.2004.03.002

## Description

La présente invention concerne un procédé de contrôle de la température d'un flux de fluide destiné à être utilisé par une sonde d'analyse par résonance magnétique nucléaire (RMN), dit « premier flux », et un dispositif de contrôle correspondant. L'invention concerne aussi un procédé de fonctionnement d'un système d'analyse RMN et un système d'analyse RMN correspondant.

Un système d'analyse par résonance magnétique nucléaire (RMN) comprend une sonde d'analyse RMN, un circuit de circulation d'un flux de fluide destiné à être utilisé par la sonde et un dispositif de contrôle de la température du flux destiné à la sonde, tel qu'un cryostat.

La sonde comporte un porte-échantillon destiné à recevoir un échantillon de matière à analyser. En fonctionnement, le porte-échantillon est entraîné en rotation dans un champ magnétique statique et exposé à un second champ magnétique perpendiculaire au premier. Le second champ magnétique peut être produit par une bobine radiofréquence. En retour, la bobine reçoit un signal qui est analysé pour obtenir des informations sur l'échantillon. Le flux de fluide utilisé par la sonde peut avoir plusieurs fonctions, en particulier les fonctions suivantes :
- entraîner en rotation le porte-échantillon, par exemple en faisant tourner une turbine d'entraînement d'un rotor, ou module de rotation, qui intègre le porte-échantillon ;
- porter l'échantillon à une température souhaitée appartenant à une gamme de températures adaptée pour réaliser un spectre d'analyse RMN, par exemple entre 300K et 8K ;
- créer un palier de sustentation ou de guidage du rotor dans une partie stator.

Le fluide utilisé par la sonde est par exemple de l'hélium ou de l'azote. Il est fourni par une source telle qu'une bouteille de fluide sous pression (hélium ou azote). En fonctionnement, le fluide est entraîné en circulation dans un circuit correspondant à une boucle fermée, qui intègre notamment la sonde et le dispositif de contrôle de la température du flux de fluide destiné à la sonde. Le flux de fluide destiné à la sonde peut être divisé, en amont de la sonde, en plusieurs flux distincts respectivement destinés à réaliser les différentes fonctions précédemment mentionnées.

L'opération de contrôle thermique appliquée au flux destiné à la sonde vise à régler la température de ce flux. Il comprend un échange thermique entre le flux destiné à la sonde et un flux d'un fluide de refroidissement, appelé « flux cryogénique », au sein d'un échangeur thermique, afin de refroidir le flux destiné à la sonde. Le flux cryogénique apporte le froid en provenance d'une source froide de fluide cryogénique externe. Il circule à travers l'échangeur avec un débit donné. Généralement, le débit du flux cryogénique est fixé à une valeur maximale.

Le circuit de circulation du flux destiné à être utilisé par la sonde est adapté pour récupérer ce flux en sortie de la sonde puis le faire circuler à travers l'échangeur thermique, avant de le diriger de nouveau vers la sonde.

La fréquence de rotation du porte-échantillon dépend du débit du flux utilisé par la sonde. Pour augmenter cette fréquence de rotation, afin d'affiner la mesure du signal, il convient d'augmenter le débit du flux destiné à la sonde. Le débit du flux cryogénique étant fixe (généralement égal au débit maximal), le fait d'augmenter le débit du flux destiné à la sonde a pour effet d'augmenter la température plateau ou d'équilibre de ce flux. La demande de brevet FR 2 983 959 A1 divulgue un tel exemple de système d'analyse par RMN comprenant une sonde d'analyse RMN.

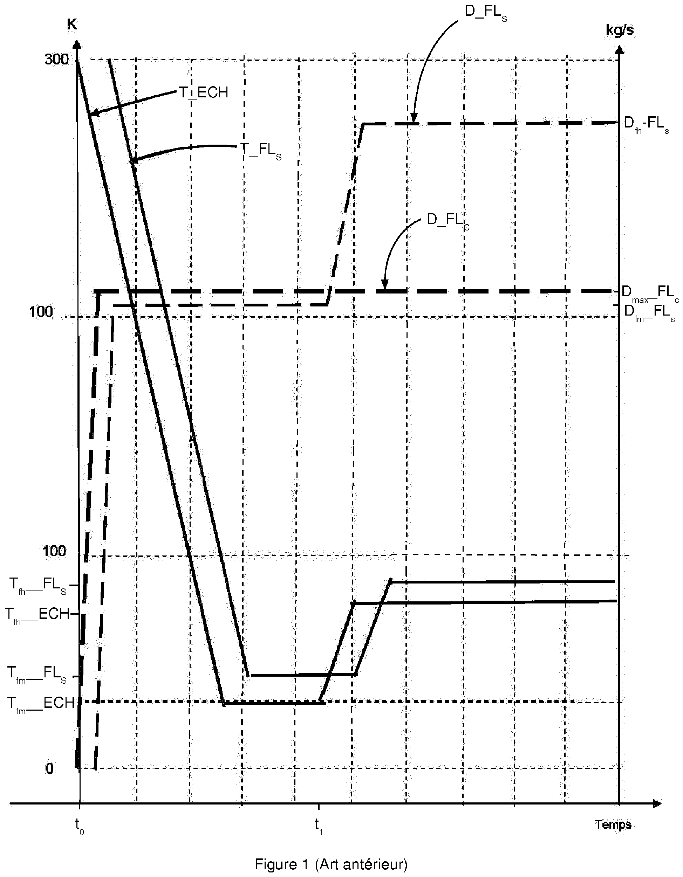

Sur la figure 1, à titre d'exemple illustratif, on a représenté les évolutions temporelles de différentes grandeurs physiques, lors du fonctionnement d'un système d'analyse RMN de l'art antérieur. Les grandeurs physiques représentées comprennent :
- la température T_FL_{S} et le débit D_FL_{S} du flux destiné à la sonde FLₛ ;
- le débit D_FL_{C} du flux cryogénique FL_{C},
- la température T_ECH de l'échangeur thermique.

A partir d'un instant t₀ de démarrage du système d'analyse RMN, les deux flux FL_{C} et FL_{S} sont mis en circulation en même temps, ou sensiblement en même temps, à travers l'échangeur thermique. Le débit du flux cryogénique D_FL_{c} augmente rapidement jusqu'à atteindre une valeur souhaitée, correspondant par exemple à un débit maximal Dₘₐₓ_FL_{C} du flux cryogénique FL_{c}, puis reste stable dans la suite du fonctionnement du système d'analyse. Parallèlement, le débit D_FL_{S} du flux de la sonde est rapidement augmenté jusqu'à atteindre un premier débit souhaité D_{fm}_FL_{S} correspondant à une fréquence de rotation modérée du porte-échantillon de la sonde d'analyse RMN puis reste stable. Suite au démarrage, la température T_FL_{S} du flux de la sonde FL_{S} diminue progressivement, par échange thermique avec le flux cryogénique FL_{C}, et se stabilise à une première valeur d'équilibre T_{fm}_FL_{S} en formant un premier plateau. Concomitamment, la température T_ECH de l'échangeur diminue également jusqu'à atteindre une première valeur d'équilibre T_{fm}_ECH formant un premier plateau (légèrement inférieur au premier plateau relatif au flux FL_{S}). Ces premiers plateaux de température, respectivement relatifs aux flux FL_{S} et FL_{C}, correspondent à un équilibre thermique entre ces deux flux FL_{C} et FLS qui ont des débits respectifs Dₘₐₓ_FL_{C} et D_{fm}_FL_{S} et traversent l'échangeur thermique, pour une fréquence de rotation modérée fₘ du porte-échantillon de la sonde.

A partir d'un instant t₁, le débit D_FL_{S} est brutalement augmenté jusqu'à atteindre un deuxième débit D_{fh}_FL_{S}, supérieur au premier et correspondant à une fréquence de rotation élevée du porte-échantillon de la sonde d'analyse RMN, puis reste stable. Suite à l'augmentation du débit D_FL_{S}, la température T_FL_{S} du flux de la sonde FL_{S} augmente progressivement et se stabilise à une deuxième valeur d'équilibre T_{fh}_FL_{S} en formant un deuxième plateau. Concomitamment, la température T_ECH de l'échangeur augmente également jusqu'à atteindre une deuxième valeur d'équilibre T_{fh}_ECH formant un deuxième plateau (légèrement inférieur au deuxième plateau relatif au flux FL_{S}). Ces deuxièmes plateaux thermiques, respectivement relatifs aux flux FL_{C} et FL_{S}, correspondent à un équilibre thermique entre les deux flux FL_{C} et FL_{S} qui ont des débits respectifs Dₘₐₓ_FL_{C} et D_{fh}_FL_{S} et traversent l'échangeur thermique, pour une fréquence de rotation haute du porte-échantillon de la sonde.

On soulignera que les deuxièmes plateaux thermiques relatifs à une fréquence de rotation haute de la sonde sont plus élevés que les premiers plateaux thermiques relatifs à une fréquence de rotation modérée de la sonde. En définitive, avec le système de l'art antérieur, on doit privilégier soit la fréquence de rotation, soit la température de fonctionnement de la sonde. Typiquement, la sonde peut être utilisée soit à très basse température de fonctionnement (par exemple inférieure à 20K) avec une fréquence de rotation modérée (par exemple de l'ordre de 5kHz), soit à une température de fonctionnement plus élevée (par exemple supérieure à 40K) avec une fréquence de rotation élevée (par exemple de l'ordre de 15 à 20 kHz).

La présente invention vient améliorer la situation.

A cet effet, l'invention concerne un procédé de contrôle de la température d'un premier flux de fluide destiné à être utilisé par une sonde d'analyse par résonance magnétique nucléaire pour entraîner en rotation un porte-échantillon de la sonde avec une fréquence de rotation donnée dépendant d'un débit du premier flux, comportant une opération de circulation du premier flux, lors de laquelle ledit premier flux traverse un échangeur thermique avec un premier débit, caractérisé en ce qu'il comprend une étape initiale de refroidissement lors de laquelle on baisse la température de l'échangeur thermique, et, concomitamment, on règle le débit dudit premier flux à un débit initial qui est inférieur au premier débit, et, suite à ladite étape initiale de refroidissement, on déclenche l'opération de circulation du premier flux avec le premier débit.

Dans un mode de réalisation particulier, le débit initial du premier flux est réglé à zéro.

Dans une variante particulière de réalisation, le premier flux circulant à travers un circuit, le débit initial dudit premier flux est réglé à une valeur adaptée de sorte à ce que la pression à l'intérieur dudit circuit soit supérieure ou égale à la pression à l'extérieur dudit circuit. Grâce à cela, on peut créer une légère surpression dans le circuit, permettant d'éviter l'entrée d'élément externes polluants dans le circuit.

L'étape initiale de refroidissement permet de refroidir l'échangeur thermique avant de déclencher la circulation du premier flux avec le premier débit. L'échangeur ayant une certaine masse et donc une certaine inertie thermique constitue, à l'issue de l'étape initiale de refroidissement, un réservoir d'énergie thermique, de type réservoir de froid, capable d'intensifier le refroidissement du flux destiné à la sonde juste après qu'il a commencé à circuler avec le premier débit à travers l'échangeur. Il en résulte que la température du flux destiné à la sonde descend en deçà de sa température d'équilibre correspondant au premier débit de circulation réglé, avant de remonter jusqu'à cette température d'équilibre alors que le premier flux circule déjà avec le débit souhaité. Le premier débit de circulation du premier flux peut être réglé à un niveau haut correspondant à une fréquence de rotation haute de la sonde. Grâce à l'invention, on fait descendre la température du premier flux, qui circule avec un premier débit souhaité, à une valeur très basse qui est inférieure à la température à l'équilibre thermique du premier flux. On peut donc obtenir à la fois une température basse du premier flux destiné à être utilisé par la sonde (inférieure à sa température d'équilibre) et un débit élevé correspondant à une fréquence de rotation haute du porte-échantillon de la sonde.

Avantageusement, lors de l'étape initiale de refroidissement, on baisse la température de l'échangeur thermique jusqu'à une valeur basse qui est inférieure à une valeur d'équilibre atteinte après mise en circulation du premier flux destiné avec le premier débit.

Dans un mode de réalisation particulier, lors de l'étape initiale, on fait circuler à travers l'échangeur thermique un deuxième flux d'un fluide de refroidissement, avec un débit tel qu'un débit maximal dudit flux de refroidissement.

Avantageusement, lors de l'étape initiale, la température de l'échangeur est baissée jusqu'à une valeur basse qui correspond à une température d'équilibre minimale de l'échangeur thermique traversé par le deuxième flux de refroidissement.

Selon un premier aspect de l'invention, suite au déclenchement de l'opération de circulation du premier flux, le premier débit dudit premier flux étant réglé à une valeur souhaitée, l'évolution dans le temps de la température du premier flux comprend successivement une première phase de baisse de ladite température, une deuxième phase transitoire comportant une hausse de ladite température jusqu'à une valeur d'équilibre et une troisième phase d'équilibre où ladite température est stable et égale à la valeur d'équilibre, ladite phase transitoire étant d'une durée adaptée de sorte à permettre à la sonde de réaliser un spectre RMN d'un échantillon. Durant la phase transitoire, la température du premier flux traverse un domaine de températures qui est inférieur à la température d'équilibre du premier flux, alors que le débit de circulation de ce premier flux est déjà réglé à une valeur souhaitée, par exemple une valeur correspondant à une fréquence de rotation haute du porte-échantillon de la sonde.

Selon un deuxième aspect de l'invention, le premier flux, en cours de circulation avec le premier débit, traverse un module de chauffage et en ce que la puissance de chauffage dudit module est portée à une valeur haute puis diminuée de sorte à ce que la température du premier flux soit provisoirement stable durant une partie de la phase transitoire, notamment une première partie de la phase transitoire. Grâce à cela, on réalise un plateau thermique stable à une valeur basse de la température du premier flux, alors que la circulation de ce premier flux est déjà réglée avec le premier débit. Un tel plateau thermique est très intéressant pour réaliser une analyse RMN.

Avantageusement, le premier flux en circulation traverse le module de chauffage en aval de l'échangeur thermique dans le sens de circulation dudit premier flux. Le module de chauffage peut comprendre une résistance électrique.

Avantageusement encore, ledit premier débit du premier flux est réglé à une valeur correspondant à une fréquence supérieure ou égale à une fréquence de rotation limite, notamment supérieure ou égale à 10kHz.

L'invention concerne aussi un procédé de fonctionnement d'un système d'analyse par résonance magnétique nucléaire comportant une sonde d'analyse par résonance magnétique nucléaire d'un échantillon, un circuit de circulation d'un premier flux de fluide destiné à être utilisé par ladite sonde et un dispositif de contrôle de la température dudit premier flux comportant un échangeur thermique, caractérisé en ce que la température du premier flux est contrôlée par ledit dispositif de contrôle par la mise en oeuvre des étapes du procédé de contrôle précédemment défini.

Dans un premier mode de réalisation, la température du premier flux étant contrôlée par le procédé de contrôle tel que précédemment défini, la sonde réalise un spectre RMN d'un échantillon durant ladite phase transitoire.

Dans un deuxième mode de réalisation, la température du premier flux étant contrôlée par le procédé de contrôle tel que précédemment défini, la sonde réalise un spectre RMN d'un échantillon lorsque la température du premier flux est provisoirement stable durant une partie de la phase transitoire.

L'invention concerne aussi un dispositif de contrôle de la température d'un premier flux d'un fluide destiné à être utilisé par une sonde d'analyse par résonance magnétique nucléaire pour entraîner en rotation un porte-échantillon avec une fréquence de rotation dépendant du débit du premier flux, intégrant au moins un échangeur thermique à travers lequel le premier flux est destiné à circuler avec un premier débit, caractérisé en ce qu'il comprend un module de commande agencé pour commander une baisse initiale de la température de l'échangeur thermique et pour concomitamment régler le débit du premier flux à un débit initial inférieur au premier débit, puis pour déclencher une circulation du premier flux à travers l'échangeur avec le premier débit.

Dans une forme de réalisation, le module de commande est agencé pour régler le débit initial à zéro.

Dans une variante de réalisation, le premier flux circulant à travers un circuit, le module de commande est agencé pour régler le débit initial dudit premier flux à une valeur adaptée de sorte à ce que la pression à l'intérieur dudit circuit soit supérieure ou égale à la pression à l'extérieur dudit circuit.

Ce dispositif comprend avantageusement tout ou partie des caractéristiques additionnelles suivantes :
- l'échangeur thermique est adapté pour être traversé par un deuxième flux d'un fluide de refroidissement et en ce que le module de commande est agencé pour commander initialement une circulation du deuxième flux de refroidissement avec un débit tel qu'un débit maximal dudit flux de refroidissement, afin d'obtenir la baisse initiale de la température de l'échangeur ;
- le module de commande est adapté pour commander une baisse initiale de la température de l'échangeur jusqu'à une valeur basse qui correspond à une température d'équilibre minimale de l'échangeur thermique traversé par le deuxième flux, avant de déclencher la circulation du premier flux avec le premier débit ;
- il comprend un module de chauffage destiné à fournir une puissance thermique au premier flux et en ce que le module de commande est adapté pour piloter le module de chauffage de sorte à ce que la puissance thermique fournie soit maximale après déclenchement de la circulation du premier flux avec le premier débit puis diminue de façon adaptée pour que la température du premier flux soit provisoirement stable ;
- le module de chauffage est disposé en aval de l'échangeur thermique dans le sens de circulation du premier flux ;
- le module de chauffage comprend une résistance électrique.

L'invention concerne encore un système d'analyse par résonance magnétique nucléaire comportant une sonde d'analyse par résonance magnétique nucléaire d'un échantillon, un circuit de circulation d'un premier flux de fluide destiné à être utilisé par ladite sonde et un dispositif de contrôle de la température du premier flux tel que précédemment défini.

Selon une première forme de réalisation, le système d'analyse RMN comprend un module de commande agencé pour commander la réalisation d'un spectre par la sonde, après déclenchement de la circulation du premier flux avec le premier débit, durant une phase transitoire postérieure à une baisse initiale de la température du premier flux jusqu'à une valeur basse et antérieure à une phase d'équilibre de la température du flux destiné à la sonde à une valeur supérieure à ladite valeur basse.

Selon une deuxième forme de réalisation, le système d'analyse RMN comprend un dispositif de contrôle de la température du premier flux tel que précédemment défini et en ce que le module de commande est agencé pour commander la réalisation d'un spectre par la sonde, lorsque la température du premier flux est provisoirement stable durant ladite phase transitoire.

L'invention sera mieux comprise à l'aide de la description suivante d'un procédé de contrôle de la température d'un flux de fluide destiné à être utilisé par une sonde d'analyse RMN, dit « premier flux », et d'un procédé de fonctionnement d'un système d'analyse RMN, selon différents modes de réalisation de l'invention, ainsi que d'un dispositif de contrôle et d'un système d'analyse RMN correspondants, en référence aux dessins annexés sur lesquels :
- la figure 2 représente les évolutions temporelles de différentes grandeurs physiques (débits, températures) lors de la mise en oeuvre du procédé de contrôle de la température du premier flux destiné à la sonde d'analyse RMN pendant le fonctionnement du système d'analyse RMN, selon un premier mode de réalisation particulier de l'invention ;
- la figure 3 représente les évolutions temporelles de différentes grandeurs physiques (débits, températures) lors de la mise en oeuvre du procédé de contrôle de la température du premier flux destiné à la sonde d'analyse RMN pendant le fonctionnement du système d'analyse RMN, selon un deuxième mode de réalisation particulier de l'invention ;
- La figure 4 représente un système d'analyse RMN selon une forme de réalisation particulière adaptée pour fonctionner conformément à la figure 3 ;
- La figure 5A représente un organigramme des étapes du procédé de fonctionnement du système d'analyse RMN intégrant un procédé de contrôle de la température du premier flux correspondant à la figure 2 ;
- La figure 5B représente un organigramme des étapes du procédé de fonctionnement du système d'analyse RMN intégrant un procédé de contrôle de la température du premier flux correspondant à la figure 3.

Par souci de clarté, sur les différentes figures, les éléments analogues ou correspondants des différents modes, variantes et/ou exemples de réalisation de l'invention portent les mêmes références, sauf indication spécifique contraire.

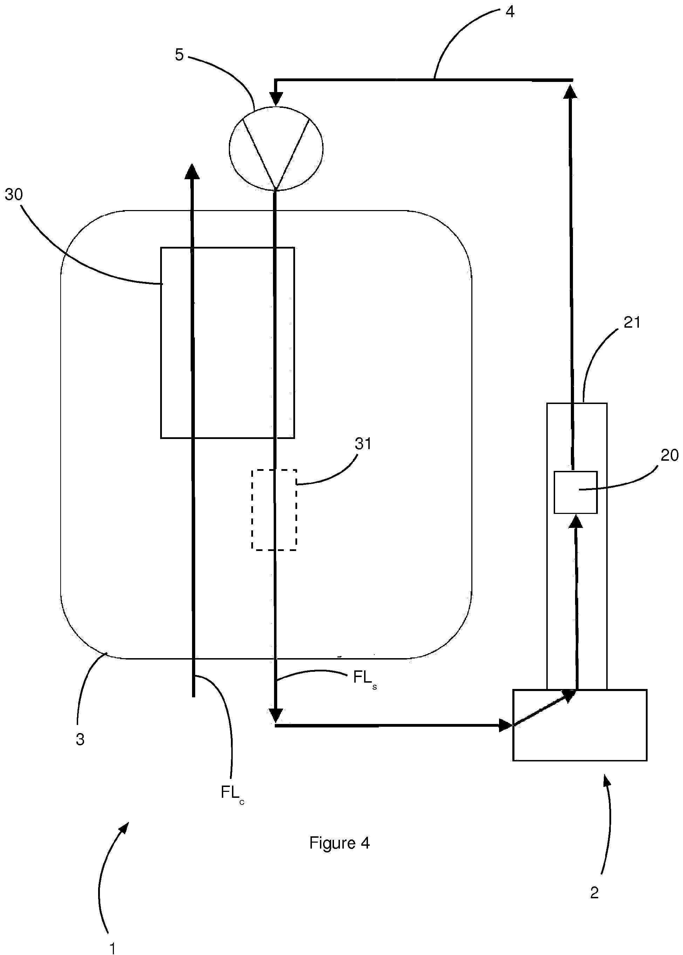

Sur la figure 4, on a représenté un système 1 d'analyse par résonance magnétique nucléaire (RMN). Selon une première forme de réalisation de l'invention, le système comprend :
- une sonde 2 d'analyse par résonance magnétique nucléaire ;
- un dispositif 3 de contrôle de la température d'un flux de fluide destiné à être utilisé par la sonde, dit « premier flux » ;
- un circuit 4 de circulation du premier flux destiné à être utilisé par la sonde ;
- un module de commande (non représenté).

La sonde d'analyse RMN 2, représentée de façon schématique sur la figure 4, comprend un porte-échantillon 20 destiné à recevoir un échantillon à analyser. Le porte-échantillon 20 est intégré dans un rotor (non représenté) équipé par exemple d'une turbine d'entraînement en rotation. Le rotor est placé dans un stator 21. Celui-ci est lui-même situé, de façon connue, au centre magnétique du dispositif complet de RMN.

Le circuit de circulation 4 est destiné à faire circuler en boucle fermée un flux d'un fluide, destiné à être utilisé par la sonde 2.

Le fluide est par exemple de l'hélium ou de l'azote. Il provient d'une source telle qu'un container standard, par exemple une bouteille de fluide sous pression. Il est destiné à être mis en circulation dans le circuit 4 sous forme d'un flux FL_{S} destiné à être utilisé par la sonde 2. Ce flux peut avoir plusieurs fonctions au sein de la sonde 2. Dans l'exemple de réalisation décrit ici, il a pour fonction d'entraîner en rotation le porte-échantillon 20 et de porter l'échantillon à une température souhaitée pour réaliser une analyse par RMN. Cette température est par exemple comprise entre 8K et 300K. Le porte-échantillon 20 entraîné en rotation par le flux FL_{S} a une fréquence de rotation qui dépend du débit du flux FL_{S}. Le flux FL_{S} peut être divisé dans la sonde pour produire des flux distincts respectivement destinés à exécuter les différentes fonctions.

Le circuit de circulation est adapté de sorte à ce que le flux FL_{S} traverse le dispositif de contrôle 3 et la sonde 2. Il comprend un module de compression 5 comportant au moins un compresseur de type compresseur-circulateur. Ce module de compression 5 est agencé dans la boucle fermée pressurisée de sorte à assurer la circulation du flux FL_{S} dans cette boucle. Dans l'exemple de réalisation décrit ici, il est disposé entre une sortie de flux du dispositif d'analyse RMN et une entrée de flux du dispositif de contrôle 3. Il pourrait toutefois être disposé en une position différente le long du circuit 4. Il pourrait notamment être placé à l'intérieur du cryostat 3.

Le dispositif de contrôle 3 est destiné à contrôler (c'est-à-dire à régler ou gérer) la température du premier flux FL_{S} afin d'assurer un réglage de la température de ce premier flux FL_{S}. Il s'agit ici d'un cryostat. Dans une première forme de réalisation particulière de l'invention, le dispositif 3 intègre un échangeur thermique 30. Dans cet exemple de réalisation, l'échangeur thermique 30 est agencé de sorte à assurer un échange thermique entre un flux de refroidissement, dit « deuxième flux » » et le premier flux FL_{S} destiné à la sonde 2. Le deuxième flux de refroidissement, également appelé flux cryogénique et noté FL_{C}, provient d'une source froide de fluide cryogénique externe (non représentée). En fonctionnement, il traverse l'échangeur thermique 30 avec un débit D_FL_{C} donné égal ou inférieur à un débit maximal Dₘₐₓ_FL_{C}. Les flux FL_{C} et FL_{S} sont ici destinés à traverser l'échangeur thermique 30 en sens opposés.

Dans un autre exemple de réalisation, l'échangeur thermique 30 est refroidi grâce à une machine de production de froid intercalée entre l'aval de l'échangeur et l'amont de la sonde (l'aval et l'amont faisant référence au sens de circulation du premier flux FL_{S}). Dans ce cas, il n'y a pas alors de deuxième flux FL_{C}.

Le module de commande comprend un micro-processeur et des éléments logiciels adaptés pour commander le fonctionnement des différents éléments du système d'analyse RMN 1, notamment du dispositif de contrôle thermique 3. En variante, on pourrait prévoir deux modules de commande, l'un destiné à commander le fonctionnement de la sonde et l'autre destiné à commander la circulation des fluides FL_{C} et FL_{S} et le fonctionnement du dispositif de contrôle thermique. Le ou les modules de commande sont adaptés pour commander l'exécution des étapes du procédé de contrôle de la température du premier flux et des étapes du procédé de fonctionnement du système d'analyse RMN 1, qui seront décrites ci-après.

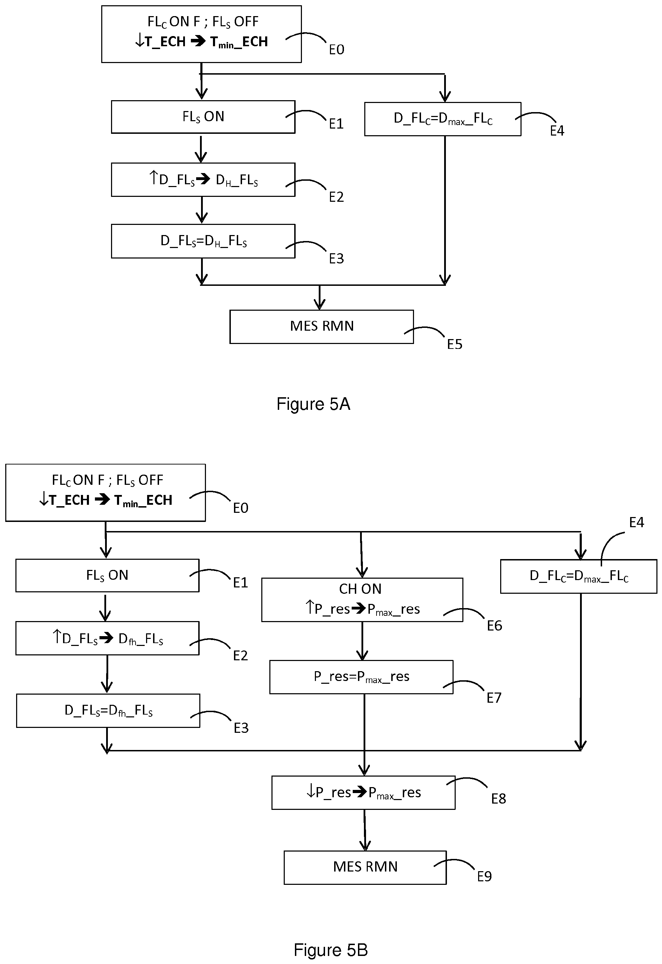

En référence à la figure 5, on va maintenant décrire le procédé de fonctionnement du système d'analyse RMN 1, selon un premier mode de réalisation particulier de l'invention. Ce procédé de fonctionnement comprend la mise en œuvre d'un procédé de contrôle de la température du premier flux destiné à être utilisé par la sonde FL_{S}, pour entraîner en rotation un porte-échantillon avec une fréquence de rotation dépendant du débit du flux FL_{S} et pour refroidir l'échantillon, selon un premier mode de réalisation, comme cela apparaîtra dans la description qui suit.

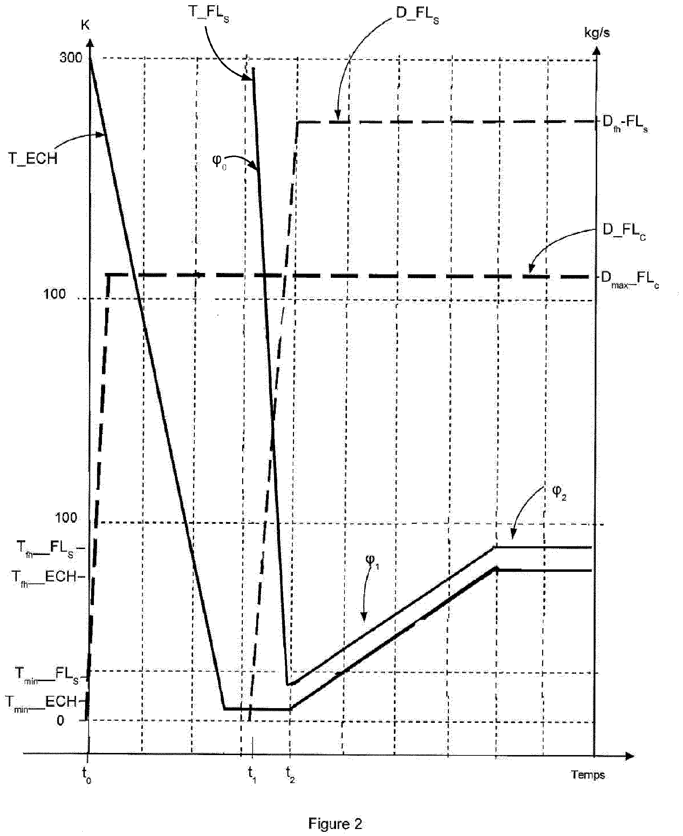

En référence aux figures 2 et 5A, le procédé de fonctionnement du système d'analyse RMN 1 comprend une étape initiale E0 de baisse de la température T_ECH de l'échangeur thermique.

La température de l'échangeur est mesurée par une ou plusieurs sondes placées sur ou dans le corps de l'échangeur 30. Il n'est pas nécessaire de mesurer la valeur absolue de la température T_ECH. Il suffit ici de mesurer une variation de cette température T_ECH afin de suivre son évolution dans le temps. On peut par exemple faire une mesure ponctuelle de la température et/ou déterminer une température moyenne à partir de plusieurs points de mesure.

L'étape E0 consiste à faire circuler le flux cryogénique FL_{C} à travers l'échangeur 30 mais ici sans circulation du premier flux FL_{S} destiné à la sonde. Autrement dit le débit initial du premier flux est égal à zéro : D_FL_{S}=0. Initialement, à un instant t₀, le débit du flux cryogénique, ou deuxième flux, noté D_FL_{C}, est nul. Lors de l'étape E0, à compter de cet instant t₀, on déclenche la circulation du fluide cryogénique FL_{C} dont le débit D_FL_{C} passe rapidement de zéro à une valeur souhaitée, par exemple égale au débit maximal du fluide FL_{C} (c'est-à-dire le débit le plus élevé auquel ce fluide peut circuler à travers l'échangeur 30), noté Dₘₐₓ_FL_{C}. Lors de l'étape E0, l'échangeur 30 fonctionne donc avec une circulation du deuxième fluide cryogénique FL_{C} mais sans circulation du premier flux FL_{S}. Il en résulte une chute de la température de l'échangeur T_ECH jusqu'à atteindre une valeur basse souhaitée. Celle-ci peut correspondre à une température minimale Tₘᵢₙ_ECH stable (ou d'équilibre) de l'échangeur thermique 30 traversé uniquement par le flux cryogénique FL_{C}. Toutefois, on pourrait ne pas diminuer la température de l'échangeur 30 jusqu'à la température minimale d'équilibre Tₘᵢₙ_ECH. On pourrait par exemple baisser la température de l'échangeur 30 jusqu'à une température basse choisie en fonction d'une application finale. En toute hypothèse, lors de l'étape initiale de refroidissement, on baisse avantageusement la température de l'échangeur thermique 30 jusqu'à une valeur basse qui est inférieure à une valeur d'équilibre T_{fh}_ECH qui sera atteinte ultérieurement après la mise en circulation du premier flux FL_{S} avec un débit opérationnel, ou « premier débit ».

Après que la température de l'échangeur 30 a atteint la valeur basse souhaitée (ici Tₘᵢₙ_ECH), l'étape intiale E0 peut être poursuivie pendant une courte durée de sorte à maintenir provisoirement la température basse (ici Tₘᵢₙ_ECH) de l'échangeur 30 en attendant de déclencher l'étape suivante E1.

Dans une variante particulière de réalisation, l'étape initiale E0 de refroidissement de l'échangeur 30 est mise en œuvre avec une circulation du premier flux FL_{S} mais à un débit D_FL_{S} faible. Par exemple, le débit D_FL_{S} est réglé à une faible valeur permettant de mettre le circuit 4 en légère surpression par rapport à l'extérieur et à éviter ainsi une pollution en provenance de l'extérieur.

L'échangeur thermique 30 ayant une certaine masse, de l'ordre de plusieurs dizaines de kilogrammes, cette étape initiale, ou préalable, de refroidissement E0 permet de « charger » l'échangeur 30 avec des frigories. A l'issue de l'étape E0, l'échangeur 30 constitue un réservoir d'énergie thermique, de type réservoir de froid. L'échangeur 30 ayant une certaine inertie thermique, ce réservoir est utilisable postérieurement à l'étape E0 pour accentuer le refroidissement du premier flux destiné à la sonde FL_{S}, comme cela apparaîtra dans la description qui suit.

A l'issue de l'étape E0, à un instant t₁, le module de commande déclenche une circulation du premier flux de fluide FL_{S} destiné à être utilisé par la sonde 2, lors d'une étape E1.

Lors d'une étape E2, le débit du premier flux destiné à la sonde FL_{S}, nul avant l'instant t₁, est rapidement augmenté et réglé à un premier débit fixe strictement supérieur à zéro constituant un débit opérationnel. Ce premier débit réglé, noté D_{fh}_FL_{S}, est ici adapté pour faire tourner le porte-échantillon 20 à une fréquence de rotation haute « fₕ », par exemple supérieure à 10Hz, par exemple encore comprise entre 10 et 20 kHz. Le premier débit du premier flux FL_{S} est ainsi réglé à une valeur correspondant à une fréquence supérieure ou égale à une fréquence de rotation limite (cette fréquence limite étant par exemple égale à 10kHz). Par définition, la fréquence de rotation limite est la fréquence de rotation atteinte lorsque l'échangeur 30 est stabilisé en température pour cette fréquence de rotation sans mise en œuvre de l'invention (donc sans l'étape initiale EO). Le débit haut D_{fh}_FL_{S} correspond donc à une fréquence de rotation haute « fₕ » de la sonde 2.

La circulation du premier flux FL_{S} dans le circuit 4 est ensuite maintenue, avec un débit stable égal à D_{fh}_FL_{S}, lors d'une étape E3.

Notons que, suite à l'étape E0 et concomitamment aux étapes E1 et suivantes, la circulation du deuxième flux FL_{C} à travers l'échangeur 30 avec un débit ici égal à Dₘₐₓ_FL_{C} est maintenue, comme représenté par l'étape E4 sur la figure 5A.

La circulation du premier flux FL_{S} avec le débit réglé, ici égal à D_{fh}_FL_{S}, étant établie par exécution des étapes E0 à E4, la température du flux FL_{S} est contrôlée, ou gérée, par le dispositif de contrôle 3, notamment en traversant l'échangeur thermique 30. Il en résulte une évolution dans le temps de la température du premier flux FL_{S} qui comprend trois phases successives ϕ₀, ϕ₁ et ϕ₂, décrites ci-après.

La première phase, ou phase initiale ϕ₀, est une phase de refroidissement lors de laquelle la température du premier flux FL_{S} baisse progressivement jusqu'à atteindre une valeur basse, comme représenté sur la figure 2. Lors de cette phase initiale ϕ₀, le refroidissement du premier flux FL_{S} traversant l'échangeur 30 est provoqué par deux types de transfert thermique comprenant :
- de façon classique, un échange thermique entre le premier flux FL_{S} et le deuxième flux FL_{C}, les deux flux circulant à travers l'échangeur 30 (ici en sens opposés) et
- selon l'invention, un transfert thermique entre l'échangeur thermique 30, préalablement refroidi et jouant le rôle de réservoir de froid, et le flux FL_{S}.

Grâce à l'inertie thermique de l'échangeur 30 préalablement refroidi, le premier flux FL_{S} destiné à la sonde descend à une température bien plus basse que celle qu'il aurait atteinte avec un fonctionnement classique de l'échangeur 3 consistant à déclencher la circulation de chacun des premier et deuxième fluides FL_{S} et FL_{C} sensiblement en même temps, sans étape préalable E0 de refroidissement de l'échangeur thermique 30. Dans l'exemple décrit ici, durant la phase initiale de refroidissement du flux FL_{S}, l'échangeur thermique 30 fournit une puissance thermique de l'ordre de 2 kW.

La phase de refroidissement ϕ₀ s'achève lorsque l'énergie thermique accumulée dans la masse de l'échangeur thermique 30 est épuisée. Elle est suivie d'une deuxième phase dite transitoire ϕ₁ qui comporte une hausse de la température du premier flux FL_{S} jusqu'à une valeur d'équilibre notée T_{fh}_FL_{S}. Parallèlement, la température de l'échangeur T_ECH remonte également lors de la phase transitoire ϕ₁, jusqu'à une valeur d'équilibre notée T_{fh}_ECH.

La phase transitoire ϕ₁ est suivie d'une troisième phase, dite phase d'équilibre ϕ₂, lors de laquelle la température du premier flux FL_{S} reste stable et égale à la valeur T_{fh}_FL_{S}. Parallèlement, la température de l'échangeur T_ECH se stabilise également à la valeur d'équilibre T_{fh}_ECH. La phase d'équilibre ϕ₂ est ainsi caractérisée par un premier plateau de température du flux FL_{S} à la valeur T_{fh}_FLS et par un deuxième plateau de température de l'échangeur à la valeur T_{fh}_ECH. Ces deux plateaux de température correspondent à un équilibre thermique entre les premier et deuxième flux FL_{S} et FL_{C}, circulant avec des débits respectifs Dₘₐₓ_FL_{C} et D_{fh}_FL_{S}, à travers l'échangeur thermique 30. Pour rappel, le débit D_{fh}_FL_{S} correspond à une fréquence de rotation haute du porte-échantillon 20 de la sonde 2.

Durant la phase transitoire ϕ₁, la température du premier flux FL_{S} traverse un domaine de températures, ici compris entre Tₘᵢₙ_FL_{S} et T_{fh}_FL_{S.} Ce domaine de températures est situé en-deçà de la température d'équilibre T_{fh}_FL_{S} qui correspond à une fréquence de rotation haute fₕ de la sonde, alors que le débit du premier flux FL_{S} est déjà élevé (ici égal à D_{fh}_FL_{S}) et fait donc tourner le porte-échantillon 20 de la sonde 2 à la fréquence de rotation haute fₕ.

La phase transitoire ϕ₁ est d'une durée adaptée de sorte à permettre à la sonde 2 de réaliser un spectre RMN d'un échantillon.

Selon le premier mode de réalisation de l'invention, la sonde 2 effectue un spectre RMN d'un échantillon durant cette phase transitoire ϕ₁, lors d'une étape d'analyse par RMN E5. En effet, la mesure RMN peut se satisfaire d'une variation par exemple de quelques degrés K par minute (par exemple 5K/min).

L'invention présente un autre avantage : elle permet de diminuer les oscillations en température (amplitude et fréquence) de la sonde et ainsi de stabiliser la vitesse de rotation du porte-échantillon car l'inertie thermique (ou chaleur spécifique) du matériau constituant l'échangeur thermique est bien supérieure à l'inertie thermique (ou chaleur spécifique) du gaz. Par exemple :
- à 20K, la chaleur spécifique du matériau de l'échangeur est de l'ordre de 2 fois celle de l'He (hélium) ;
- à 40K, la chaleur spécifique du matériau de l'échangeur est de l'ordre de 10 fois celle de l'He ;
- à 60K, la chaleur spécifique du matériau de l'échangeur est de l'ordre de 25 fois celle de l'He.

Les étapes E0 à E5 sont exécutées sur commande du (ou des) module(s) de commande.

Notons que la température du premier flux FL_{S} destiné à être utilisé par la sonde 2 est contrôlée, ou gérée, par un procédé de contrôle qui comprend les étapes E0 à E4 et les phases ϕ₀ à ϕ₂. Ce procédé de contrôle ou de gestion de la température du premier flux FL_{S} fait partie du procédé de fonctionnement du système d'analyse RMN. Le procédé de fonctionnement de la sonde 2 selon le premier mode de réalisation comprend les étapes E0 à E5 et les phases ϕ₀, ϕ₁, ϕ₂.

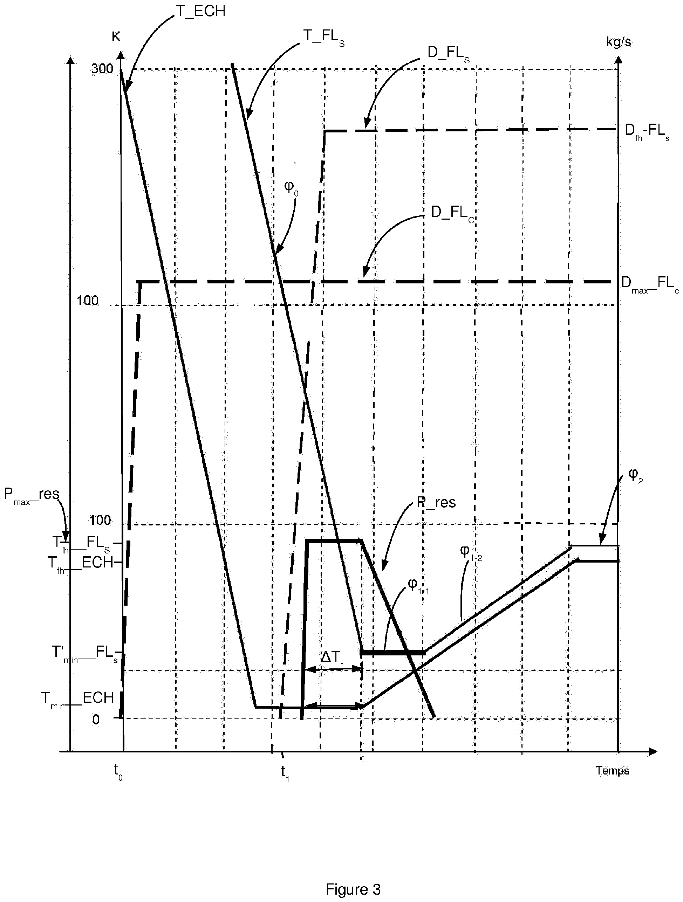

Un deuxième mode de réalisation du procédé de contrôle ou de gestion de la température du premier flux FL_{S} destiné à être utilisé par la sonde RMN 2 et du procédé de fonctionnement du système d'analyse RMN 1 va maintenant être décrit en référence aux figures 3 et 5B. Par souci de clarté, seuls les éléments de ce deuxième mode qui diffèrent du premier mode de réalisation seront décrits en détail.

Pour la mise en œuvre de ce deuxième mode de réalisation, le dispositif de contrôle 3 comprend, outre l'échangeur thermique 30, un module de chauffage 31, représenté en pointillés sur la figure 4. Le dispositif 3 est ici un cryostat. Le module de chauffage 31 comporte par exemple une résistance électrique. Le circuit de circulation du premier flux FL_{S} traverse non seulement l'échangeur thermique 30 mais aussi le module de chauffage 31. Dans l'exemple décrit ici, le module de chauffage 31 est placé en aval de l'échangeur thermique 30 dans le sens de circulation du premier flux FL_{S}. Il est piloté par le module de commande. La puissance thermique de chauffage fournie par le module de chauffage 31 peut être réglée et ajustée de sorte à contribuer au réglage de la température du premier flux FL_{S}, comme cela apparaîtra dans la description qui suit du procédé de contrôle de la température du flux FL_{S} qui suit.

En référence à la figure 5B, le procédé de contrôle comprend une étape initiale E0 de refroidissement de l'échangeur thermique 30, ici sans circulation du premier flux FL_{S}. Autrement dit, le débit initial du premier flux FL_{S} est égal à zéro : D_FL_{S}=0. Lors de l'étape E0, le deuxième flux FL_{C} circule avec un débit, ici au débit maximal D_{max_}FL_{C}. L'étape initiale E0 est suivie d'une étape E1 de déclenchement de la circulation du premier flux FL_{S} puis d'une étape E2 de réglage du débit du flux D_FL_{S} à un premier débit strictement supérieur à zéro. Ce premier débit, noté D_{fh}_FL_{S}, correspond ici à une fréquence de rotation haute fₕ de la sonde 2. Ensuite, le procédé comprend une étape E3 de circulation du flux FLₛ avec le premier débit fixe D_{fh}_FL_{S}.

Selon le deuxième mode de réalisation de l'invention, le premier flux FL_{S} circulant avec le premier débit traverse le module de chauffage 31, ici après avoir traversé l'échangeur thermique 30. Au départ (c'est-à-dire à compter de l'instant initial to), le module de chauffage 31 est ici à l'arrêt, la puissance thermique de chauffage fournie étant nulle. Lors d'une étape E6 (figure 5B), la puissance thermique du module de chauffage thermique 31, notée P_res, est brutalement augmentée jusqu'à atteindre un niveau de puissance haut. Autrement dit, la puissance de chauffage du module 31 est portée à une valeur haute. Ce niveau haut de puissance est ici maintenu stable pendant une courte durée ΔT1, lors d'une étape E7, et forme ainsi un plateau de puissance comme représenté sur le figure 3. Il correspond ici à la puissance thermique maximale Pₘₐₓ_res que peut fournir la résistance thermique. Cette puissance thermique Pₘₐₓ_res est ici de l'ordre de quelques centaines de watts. L'étape E6 est ici déclenchée légèrement après le déclenchement de la circulation du premier flux FL_{S} lors de l'étape E2.

En variante, l'étape E6 pourrait être déclenchée concomitamment à l'étape E2 ou sensiblement avant celle-ci. On pourrait également envisager de porter la puissance thermique de chauffage P_res à la valeur de plateau souhaitée, ici Pₘₐₓ_res, à tout moment avant l'étape E1 de déclenchement de la circulation du flux FL_{S}.

Les étapes E6 et E7 sont avantageusement exécutées de sorte à ce que la puissance thermique fournie par le module de chauffage 31 soit maximale sensiblement au début ou peu après le début de l'étape E3 de circulation du flux FL_{S} avec le débit fixe réglé (ici D_{fh}_FL_{S}).

L'étape E7 est suivie d'une étape E8 de baisse de la puissance thermique de chauffage fournie par le module de chauffage 31. Lors de cette étape E8, le module de chauffage 31 (ici la résistance électrique) est piloté de sorte à réduire la puissance thermique de chauffage P_res pour la faire passer de P_{max_}res à zéro.

Ainsi, le premier flux FL_{S} en circulation avec le premier débit est d'abord refroidi en traversant l'échangeur thermique 30 jusqu'à une température très basse, ici T'ₘᵢₙ_FL_{S}, puis légèrement réchauffé en traversant le module de chauffage 31 dont la puissance a été portée à Pₘₐₓ_res. Dans l'exemple décrit ici, l'échangeur 30 fournit une puissance de l'ordre de 2kW alors que le module de chauffage 31 fournit quelques centaines de watts. La diminution de la puissance thermique de chauffage P_res depuis le niveau haut de puissance (ici Pₘₐₓ_res) est ajustée, ou adaptée, de sorte à ce que la température du flux FL_{S} destiné à la sonde soit provisoirement stable et égale à T'ₘᵢₙ_FL_{S} durant une partie de la phase transitoire ϕ₁, ici durant une première partie de la phase transitoire. Le module de commande pilote ainsi le module de chauffage 31 pour que la puissance thermique de chauffage fournie soit maximale juste après déclenchement de la circulation dudit flux FL_{S} destiné à la sonde puis diminue de façon adaptée pour que la température du flux FL_{S} destiné à la sonde 2 soit provisoirement stable.

L'évolution dans le temps de la température du premier flux FL_{S} destiné à la sonde 2 comprend, comme dans le premier mode de réalisation, les trois phases successives suivantes :
- une phase ϕ₀ de refroidissement de la température ;
- une phase transitoire ϕ₁ , comportant une hausse de la température ;
- une phase d'équilibre ϕ₂, lors de laquelle la température demeure stable et égale à une valeur d'équilibre.

Ces phases ϕ₀, ϕ₁, ϕ₂ sont analogues à celles du premier mode de réalisation décrit mais en diffèrent par les aspects suivants :
- la valeur basse de la température atteinte à la fin de la phase de refroidissement ϕ₀, T'ₘᵢₙ_FL_{S}, selon le deuxième mode de réalisation est légèrement supérieure à la valeur basse Tₘᵢₙ_FL_{S} atteinte à la fin de la phase ϕ₀ selon le premier mode de réalisation ;
- la phase transitoire ϕ₁ comprend un plateau de température stable (noté ϕ_{1_1}) ici égale à la température minimale T'ₘᵢₙ_FL_{S}, avant une remontée (notée ϕ_{1_2}) de la température T_FL_{S} du premier flux FL_{S} jusqu'à la température d'équilibre T_{fh}_FL_{S}.

Dans l'exemple de réalisation décrit ici, le plateau thermique relatif au premier flux FL_{S} durant la phase transitoire ϕ₁ est situé dans la première partie de cette phase transitoire ϕ₁ qui fait passer la température du premier flux FL_{S} de la valeur la plus basse atteinte T'ₘᵢₙ_FL_{S} à la valeur d'équilibre T_{fh}_FL_{S}. En variante, on pourrait envisager que ce plateau thermique soit situé postérieurement dans la phase transitoire ϕ₁ après une première hausse de la température T_FL_{S}, et avant une deuxième hausse de la température T_FL_{S} jusqu'à la température d'équilibre T_{fh}_FL_{S}.

Soulignons que, durant la phase transitoire ϕ₁, et notamment durant le plateau thermique relatif à la température T_FL_{S}, la température du premier flux FL_{S}, ici égale à la valeur T'ₘᵢₙ_FL_{S}, est inférieure à la température d'équilibre T_{fh}_FL_{S} (correspondant à une fréquence de rotation haute fₕ de la sonde 2), alors que le débit du premier flux FL_{S} est déjà réglé à la valeur souhaitée (ou premier débit), ici égale à D_{fh}_FL_{S}, et fait donc tourner le porte-échantillon 20 de la sonde 2 à la fréquence de rotation souhaitée, ici une fréquence haute fₕ.

Selon le deuxième mode de réalisation de l'invention, la sonde 2 effectue un spectre RMN d'un échantillon durant le plateau thermique relatif au premier flux FL_{S} réalisé durant la phase transitoire ϕ₁, lors d'une étape d'analyse par RMN E9.

Le procédé de contrôle de la température du premier flux FL_{S} selon le deuxième mode de réalisation comprend les étapes EO-E4 et E6-E8 ainsi que les phases ϕ₀, ϕ₁, ϕ₂, qui viennent d'être décrites en référence aux figures 3 et 5B. Le procédé de fonctionnement de la sonde 2 selon le deuxième mode de réalisation comprend les étapes EO-E4 et E6-E8, les phases ϕ₀, ϕ₁, ϕ₂, et l'étape d'analyse E9.

Dans les deux modes de réalisation qui viennent d'être décrits en référence aux figures 2, 5A et 3, 5B, lors de l'étape initiale E0 de refroidissement de l'échangeur, il n'y pas de circulation du premier flux FL_{S}. Autrement dit, le débit initial du flux FL_{S} est nul. En variante, lors de l'étape initiale E0, on pourrait faire circuler le premier flux FL_{S} avec un débit initial D₀_FL_{S} strictement inférieur au premier débit (qui est par exemple égal à au débit D_{fh}_FL_{S}) réglé postérieurement à l'étape initiale EO. Le débit initial D₀_FL_{S} du premier flux FL_{S} peut notamment être réglé à une valeur adaptée de sorte à ce que la pression à l'intérieur du circuit 4 dans lequel le flux FL_{S} circule soit supérieure ou égale à la pression ambiante de ce circuit 4 (c'est-à-dire à la pression à l'extérieur du circuit).

## Revendications

1. Procédé de contrôle de la température d'un premier flux de fluide (FL_{S}) destiné à être utilisé par une sonde (2) d'analyse par résonance magnétique nucléaire pour entraîner en rotation un porte-échantillon (20) de la sonde (2) avec une fréquence de rotation donnée dépendant d'un débit du premier flux, comportant une opération (E1-E3) de circulation du premier flux, lors de laquelle ledit premier flux (FL_{S}) traverse un échangeur thermique (30) avec un premier débit, **caractérisé en ce qu'**il comprend une étape initiale de refroidissement (E0) lors de laquelle on baisse la température (T_ECH) de l'échangeur thermique (30), et, concomitamment, on règle le débit dudit premier flux (FL_{S}) à un débit initial qui est inférieur au premier débit, et, suite à ladite étape initiale de refroidissement (E0), on déclenche (E1) l'opération de circulation du premier flux (FL_{S}) avec le premier débit.

2. Procédé selon la revendication précédente, **caractérisé en ce que** le débit initial du premier flux est réglé à zéro.

3. Procédé selon la revendication 1, **caractérisé en ce que**, le premier flux (FL_{S}) circulant à travers un circuit (4), le débit initial dudit premier flux (FL_{S}) est réglé à une valeur adaptée de sorte à ce que la pression à l'intérieur dudit circuit soit supérieure ou égale à la pression à l'extérieur dudit circuit.

4. Procédé selon l'une des revendications précédentes, **caractérisé en ce que**, lors de l'étape initiale de refroidissement, on baisse la température de l'échangeur thermique (30) jusqu'à une valeur basse qui est inférieure à une valeur d'équilibre Tfh_ECH atteinte après mise en circulation du premier flux avec le premier débit.

5. Procédé selon l'une des revendications précédentes, **caractérisé en ce que**, lors de l'étape initiale (E0), on fait circuler à travers l'échangeur thermique (30) un deuxième flux (FL_{C}) d'un fluide de refroidissement, avec un débit (Dₘₐₓ_FL_{C}) tel qu'un débit maximal dudit flux de refroidissement (FL_{C}).

6. Procédé selon la revendication précédente, **caractérisé en ce que**, lors de l'étape initiale (E0), la température (T_ECH) de l'échangeur (30) est baissée jusqu'à une valeur basse (T_{min_}FLS) qui correspond à une température d'équilibre minimale de l'échangeur thermique (30) traversé par le deuxième flux de refroidissement (FL_{C}).

7. Procédé selon l'une des revendications précédentes, **caractérisé en ce que**, suite au déclenchement de l'opération de circulation du premier flux, le premier débit (D_FL_{S}) dudit premier flux étant réglé à une valeur souhaitée, l'évolution dans le temps de la température (T_FL_{S}) du premier flux (FL_{S}) comprend successivement une première phase (ϕ₀) de baisse de ladite température, une deuxième phase transitoire (ϕ₁) comportant une hausse de ladite température jusqu'à une valeur d'équilibre et une troisième phase d'équilibre (ϕ₂) où ladite température est stable et égale à la valeur d'équilibre, ladite phase transitoire étant d'une durée adaptée de sorte à permettre à la sonde (2) de réaliser un spectre RMN d'un échantillon.

8. Procédé selon la revendication précédente, **caractérisé en ce que** le premier flux (FL_{S}), en cours de circulation avec le premier débit, traverse un module de chauffage (31) et **en ce que** la puissance de chauffage dudit module (31) est portée à une valeur haute puis diminuée de sorte à ce que la température (T_FL_{S}) du premier flux (FL_{S}) soit provisoirement stable durant une partie de la phase transitoire (ϕ₁), notamment une première partie de la phase transitoire.

9. Procédé selon la revendication précédente, **caractérisé en ce que** le premier flux (FL_{S}) en circulation traverse le module de chauffage (31) en aval de l'échangeur thermique dans le sens de circulation dudit flux (FL_{S}).

10. Procédé selon l'une des revendications 8 et 9, **caractérisé en ce que** le module de chauffage (31) comprend une résistance électrique.

11. Procédé selon la revendication précédente, **caractérisé en ce que** ledit premier débit du premier flux est réglé à une valeur correspondant à une fréquence supérieure ou égale à une fréquence de rotation limite, notamment supérieure ou égale à 10kHz.

12. Procédé de fonctionnement d'un système d'analyse par résonance magnétique nucléaire (1) comportant une sonde (2) d'analyse par résonance magnétique nucléaire d'un échantillon, un circuit (4) de circulation d'un premier flux de fluide (FL_{S}) destiné à être utilisé par ladite sonde (2) et un dispositif (3) de contrôle de la température dudit premier flux (FL_{S}) comportant un échangeur thermique (30), **caractérisé en ce que** la température du premier flux (FL_{S}) est contrôlée par ledit dispositif de contrôle (3) par la mise en œuvre des étapes du procédé de contrôle selon l'une des revendications 1 à 11.

13. Procédé selon la revendication précédente, **caractérisé en ce que** la température du premier flux étant contrôlée par le procédé de contrôle selon la revendication 7, la sonde (2) réalise un spectre RMN d'un échantillon durant ladite phase transitoire (ϕ₁)

14. Procédé selon l'une des revendications 12 et 13, **caractérisé en ce que**, la température du premier flux (FL_{S}) étant contrôlée par le procédé de contrôle selon la revendication 8, la sonde (2) réalise un spectre RMN d'un échantillon lorsque la température (T_FL_{S}) du premier flux (FL_{S}) est provisoirement stable durant une partie de la phase transitoire (ϕ₁).

15. Dispositif de contrôle de la température d'un premier flux d'un fluide destiné à être utilisé par une sonde (2) d'analyse par résonance magnétique nucléaire pour entraîner en rotation un porte-échantillon (20) de la sonde (2) avec une fréquence de rotation donnée dépendant d'un débit du premier flux, intégrant au moins un échangeur thermique (30) à travers lequel le premier flux (FL_{S}) est destiné à circuler avec un premier débit, **caractérisé en ce qu'**il comprend un module de commande agencé pour commander une baisse initiale de la température (T_ECH) de l'échangeur thermique (30) et pour concomitamment régler le débit du premier flux à un débit initial inférieur au premier débit, puis pour déclencher une circulation du premier flux (FL_{S}) à travers l'échangeur (30) avec le premier débit.

16. Dispositif selon la revendication 15, **caractérisé en ce que** le module de commande est agencé pour régler le débit initial à zéro.

17. Dispositif selon la revendication 15, **caractérisé en ce que**, le premier flux (FL_{S}) circulant à travers un circuit (4), le module de commande est agencé pour régler le débit initial dudit premier flux (FL_{S}) à une valeur adaptée de sorte à ce que la pression à l'intérieur dudit circuit soit supérieure ou égale à la pression à l'extérieur dudit circuit.

18. Dispositif selon l'une des revendications 15 à 17, **caractérisé en ce que** l'échangeur thermique (30) est adapté pour être traversé par un deuxième flux (FL_{C}) d'un fluide de refroidissement et **en ce que** le module de commande est agencé pour commander initialement une circulation du deuxième flux de refroidissement (FL_{C}) avec un débit tel qu'un débit maximal (Dₘₐₓ_FL_{C}) dudit flux de refroidissement (FL_{C}), afin d'obtenir la baisse initiale de la température de l'échangeur (30).

19. Dispositif selon la revendication précédente, **caractérisé en ce que** le module de commande est adapté pour commander une baisse initiale de la température de l'échangeur (30) jusqu'à une valeur basse (T_{min_}ECH) qui correspond à une température d'équilibre minimale de l'échangeur thermique (30) traversé par le deuxième flux (FL_{C}), avant de déclencher la circulation du premier flux (FL_{C}) avec le premier débit.

20. Dispositif selon l'une des revendications 15 à 19, **caractérisé en ce qu'**il comprend un module de chauffage (31) destiné à fournir une puissance thermique au premier flux (FL_{S}) et **en ce que** le module de commande est adapté pour piloter le module de chauffage (31) de sorte à ce que la puissance thermique fournie soit maximale après déclenchement de la circulation du premier flux (FL_{S}) avec le premier débit puis diminue de façon adaptée pour que la température (T_FL_{S}) du premier flux (FL_{S}) soit provisoirement stable.

21. Dispositif selon la revendication précédente, **caractérisé en ce que** le module de chauffage (31) est disposé en aval de l'échangeur thermique (30) dans le sens de circulation du premier flux (FL_{S}).

22. Dispositif selon l'une des revendications 20 et 21, **caractérisé en ce que** le module de chauffage (31) comprend une résistance électrique.

23. Système d'analyse par résonance magnétique nucléaire comportant une sonde (2) d'analyse par résonance magnétique nucléaire d'un échantillon, un circuit (4) de circulation d'un premier flux de fluide (FL_{S}) destiné à être utilisé par ladite sonde (2) pour entraîner en rotation un porte-échantillon (20) de la sonde (2) avec une fréquence de rotation donnée dépendant d'un débit du premier flux et un dispositif de contrôle de la température du premier flux selon l'une des revendications 15 à 22.

24. Système selon la revendication précédente, **caractérisé en ce qu'**il comprend un module de commande agencé pour commander la réalisation d'un spectre par la sonde (2), après déclenchement de la circulation du premier flux avec le premier débit, durant une phase transitoire (ϕ₁) postérieure à une baisse initiale de la température (T_FL_{S}) du premier flux (FL_{S}) jusqu'à une valeur basse (Tₘᵢₙ_FLS ; T'ₘᵢₙ_FLS) et antérieure à une phase d'équilibre (ϕ₂) de la température (T_FL_{S}) du flux destiné à la sonde (2) à une valeur supérieure à ladite valeur basse.

25. Système selon la revendication précédente, **caractérisé en ce qu'**il comprend un dispositif de contrôle de la température du premier flux selon l'une des revendications 20 à 22 et **en ce que** le module de commande est agencé pour commander la réalisation d'un spectre par la sonde (2), lorsque la température du premier flux est provisoirement stable (T'_{min_}FLS) durant ladite phase transitoire (ϕ₁).

## Patentansprüche

1. Verfahren zur Kontrolle der Temperatur eines ersten Fluidstroms (FL_{S}), der dazu bestimmt ist, von einer Kernspinresonanz-Analysesonde (2) verwendet zu werden, um einen Probenträger (20) der Sonde (2) mit einer gegebenen Drehfrequenz in Drehung zu versetzen, die von einem Durchsatz des ersten Stroms abhängt, das einen Vorgang (E1-E3) der Zirkulation des ersten Stroms aufweist, während dessen der erste Strom (FL_{S}) einen Wärmetauscher (30) mit einem ersten Durchsatz durchquert, **dadurch gekennzeichnet, dass** es einen Anfangskühlschritt (E0) enthält, während dessen die Temperatur (T_ECH) des Wärmetauschers (30) gesenkt und gleichzeitig der Durchsatz des ersten Stroms (FL_{S}) auf einen Anfangsdurchsatz geregelt wird, der niedriger ist als der erste Durchsatz, und nach dem Anfangskühlschritt (E0) der Vorgang der Zirkulation des ersten Stroms (FL_{S}) mit dem ersten Durchsatz ausgelöst wird.

2. Verfahren nach dem vorhergehenden Anspruch, **dadurch gekennzeichnet, dass** der Anfangsdurchsatz des ersten Stroms auf Null geregelt wird.

3. Verfahren nach Anspruch 1, **dadurch gekennzeichnet, dass**, da der erste Strom (FL_{S}) durch einen Kreislauf (4) zirkuliert, der Anfangsdurchsatz des ersten Stroms (FL_{S}) auf einen geeigneten Wert geregelt wird, damit der Druck im Inneren des Kreislaufs höher als der oder gleich dem Druck außerhalb des Kreislaufs ist.

4. Verfahren nach einem der vorhergehenden Ansprüche, **dadurch gekennzeichnet, dass** im Anfangskühlschritt die Temperatur des Wärmetauschers (30) bis auf einen niedrigen Wert gesenkt wird, der niedriger als ein Gleichgewichtswert Tfh_ECH ist, der nach dem Zirkulieren des ersten Stroms mit dem ersten Durchsatz erreicht wird.

5. Verfahren nach einem der vorhergehenden Ansprüche, **dadurch gekennzeichnet, dass** im Anfangsschritt (E0) ein zweiter Strom (FL_{C}) eines Kühlfluids mit einem Durchsatz (Dₘₐₓ_FL_{C}) wie einem maximalem Durchsatz des Kühlstroms (FL_{C}) durch den Wärmetauscher (30) zirkuliert.

6. Verfahren nach dem vorhergehenden Anspruch, **dadurch gekennzeichnet, dass** im Anfangsschritt (E0) die Temperatur (T_ECH) des Tauschers (30) bis auf einen niedrigen Wert (Tₘᵢₙ_FLS) gesenkt wird, der einer minimalen Gleichgewichtstemperatur des Wärmetauschers (30) entspricht, der vom zweiten Kühlstrom (FL_{C}) durchquert wird.

7. Verfahren nach einem der vorhergehenden Ansprüche, **dadurch gekennzeichnet, dass** nach dem Auslösen des Vorgangs der Zirkulation des ersten Stroms, wobei der erste Durchsatz (D_FL_{S}) des ersten Stroms auf einen gewünschten Wert geregelt ist, die zeitliche Entwicklung der Temperatur (T_FL_{S}) des ersten Stroms (FL_{S}) nacheinander eine erste Phase (ϕ₀) des Senkens der Temperatur, eine zweite Übergangsphase (ϕ₁), die ein Erhöhen der Temperatur bis zu einem Gleichgewichtswert aufweist, und eine dritte Gleichgewichtsphase (ϕ₂) enthält, in der die Temperatur stabil und gleich dem Gleichgewichtswert ist, wobei die Übergangsphase eine geeignete Dauer hat, um es der Sonde (2) zu erlauben, ein NMR-Spektrum einer Probe herzustellen.

8. Verfahren nach dem vorhergehenden Anspruch, **dadurch gekennzeichnet, dass** der erste Strom (FLs) während der Zirkulation mit dem ersten Durchsatz ein Heizmodul (31) durchquert, und dass die Heizleistung des Moduls (31) auf einen hohen Wert gebracht und dann verringert wird, so dass die Temperatur (T_FL_{S}) des ersten Stroms (FL_{S}) während eines Teils der Übergangsphase (ϕ₁), insbesondere eines ersten Teils der Übergangsphase, vorübergehend stabil ist.

9. Verfahren nach dem vorhergehenden Anspruch, **dadurch gekennzeichnet, dass** der erste Strom (FL_{S}) in Zirkulation das Heizmodul (31) stromabwärts hinter dem Wärmetauscher in Zirkulationsrichtung des Stroms (FL_{S}) durchquert.

10. Verfahren nach einem der Ansprüche 8 und 9, **dadurch gekennzeichnet, dass** das Heizmodul (31) einen elektrischen Widerstand enthält.

11. Verfahren nach dem vorhergehenden Anspruch, **dadurch gekennzeichnet, dass** der erste Durchsatz des ersten Stroms auf einen Wert geregelt wird, der einer Frequenz höher als eine oder gleich einer Grenzdrehfrequenz entspricht, insbesondere höher als oder gleich 10kHz.

12. Betriebsverfahren eines Kernspinresonanz-Analysesystems (1), das eine Kernspinresonanz-Analysesonde (2) einer Probe, einen Kreislauf (4) zur Zirkulation eines ersten Fluidstroms (FL_{S}), der dazu bestimmt ist, von der Sonde (2) verwendet zu werden, und eine Vorrichtung (3) zur Kontrolle der Temperatur des ersten Stroms (FL_{S}) aufweist, die einen Wärmetauscher (30) aufweist, **dadurch gekennzeichnet, dass** die Temperatur des ersten Stroms (FL_{S}) von der Kontrollvorrichtung (3) durch die Durchführung der Schritte des Kontrollverfahrens nach einem der Ansprüche 1 bis 11 kontrolliert wird.

13. Verfahren nach dem vorhergehenden Anspruch, **dadurch gekennzeichnet, dass**, da die Temperatur des ersten Stroms durch das Kontrollverfahren nach Anspruch 7 kontrolliert wird, die Sonde (2) während der Übergangsphase (ϕ₁) ein NMR-Spektrum einer Probe herstellt.

14. Verfahren nach einem der Ansprüche 12 und 13, **dadurch gekennzeichnet, dass**, da die Temperatur des ersten Stroms (FL_{S}) durch das Kontrollverfahren nach Anspruch 8 kontrolliert wird, die Sonde (2) ein NMR-Spektrum einer Probe herstellt, wenn die Temperatur (T_FL_{S}) des ersten Stroms (FL_{S}) während eines Teils der Übergangsphase (ϕ₁) vorübergehend stabil ist.

15. Vorrichtung zur Kontrolle der Temperatur eines ersten Stroms eines Fluids, das dazu bestimmt ist, von einer Kernspinresonanz-Analysesonde (2) verwendet zu werden, um einen Probenträger (20) der Sonde (2) mit einer gegebenen Drehfrequenz in Drehung zu versetzen, die von einem Durchsatz des ersten Stroms abhängt, die mindestens einen Wärmetauscher (30) beinhaltet, durch den der erste Strom (FL_{S}) mit einem ersten Durchsatz zirkulieren soll, **dadurch gekennzeichnet, dass** sie ein Steuermodul enthält, das eingerichtet ist, um ein Anfangsabsenken der Temperatur (T_ECH) des Wärmetauschers (30) zu steuern und gleichzeitig den Durchsatz des ersten Stroms auf einen Anfangsdurchsatz niedriger als der erste Durchsatz zu regeln, dann eine Zirkulation des ersten Stroms (FL_{S}) durch den Tauscher (30) mit dem ersten Durchsatz auszulösen.

16. Vorrichtung nach Anspruch 15, **dadurch gekennzeichnet, dass** das Steuermodul eingerichtet ist, um den Anfangsdurchsatz auf Null zu regeln.

17. Vorrichtung nach Anspruch 15, **dadurch gekennzeichnet, dass**, da der erste Strom (FL_{S}) durch einen Kreislauf (4) zirkuliert, das Steuermodul eingerichtet ist, um den Anfangsdurchsatz des ersten Stroms (FL_{S}) auf einen geeigneten Wert zu regeln, damit der Druck im Inneren des Kreislaufs höher als der oder gleich dem Druck außerhalb des Kreislaufs ist.

18. Vorrichtung nach einem der Ansprüche 15 bis 17, **dadurch gekennzeichnet, dass** der Wärmetauscher (30) geeignet ist, von einem zweiten Strom (FL_{C}) eines Kühlfluids durchquert zu werden, und dass das Steuermodul eingerichtet ist, um eine Zirkulation des zweiten Kühlstroms (FL_{C}) anfangs mit einem Durchsatz wie einem maximalen Durchsatz (Dₘₐₓ_FL_{C}) des Kühlstroms (FL_{C}) zu steuern, um die Anfangsabsenkung der Temperatur des Tauschers (30) zu erhalten.

19. Vorrichtung nach dem vorhergehenden Anspruch, **dadurch gekennzeichnet, dass** das Steuermodul geeignet ist, eine Anfangsabsenkung der Temperatur des Tauschers (30) bis auf einen niedrigen Wert (Tₘᵢₙ_ECH) zu steuern, der einer minimalen Gleichgewichtstemperatur des vom zweiten Strom (FL_{C}) durchquerten Wärmetauschers (30) entspricht, ehe die Zirkulation des ersten Stroms (FL_{S}) mit dem ersten Durchsatz ausgelöst wird.

20. Vorrichtung nach einem der Ansprüche 15 bis 19, **dadurch gekennzeichnet, dass** sie ein Heizmodul (31) enthält, das dazu bestimmt ist, eine Wärmeleistung an den ersten Strom (FL_{S}) zu liefern, und dass das Steuermodul geeignet ist, das Heizmodul (31) so zu steuern, dass die gelieferte Wärmeleistung nach dem Auslösen der Zirkulation des ersten Stroms (FL_{S}) mit dem ersten Durchsatz maximal ist, dann in geeigneter Weise abnimmt, damit die Temperatur (T_FL_{S}) des ersten Stroms (FL_{S}) vorübergehend stabil ist.

21. Vorrichtung nach dem vorhergehenden Anspruch, **dadurch gekennzeichnet, dass** das Heizmodul (31) stromabwärts hinter dem Wärmetauscher in Zirkulationsrichtung des ersten Stroms (FL_{S}) angeordnet ist.

22. Vorrichtung nach einem der Ansprüche 20 und 21, **dadurch gekennzeichnet, dass** das Heizmodul (31) einen elektrischen Widerstand enthält.

23. Kernspinresonanz-Analysesystem, das eine Kernspinresonanz-Analysesonde (2) einer Probe, einen Kreislauf (4) für die Zirkulation eines ersten Fluidstroms (FL_{S}), der dazu bestimmt ist, von der Sonde (2) verwendet zu werden, um einen Probenträger (20) der Sonde (2) mit einer gegebenen Drehfrequenz in Drehung zu versetzen, die von einem Durchsatz des ersten Stroms abhängt, und eine Kontrollvorrichtung der Temperatur des ersten Stroms nach einem der Ansprüche 15 bis 22 aufweist.

24. System nach dem vorhergehenden Anspruch, **dadurch gekennzeichnet, dass** es ein Steuermodul enthält, das eingerichtet ist, um die Herstellung eines Spektrums durch die Sonde (2), nach dem Auslösen der Zirkulation des ersten Stroms mit dem ersten Durchsatz, während einer Übergangsphase (ϕ₁) nach einer Anfangsabsenkung der Temperatur (T_FL_{S}) des ersten Stroms (FL_{S}) bis auf einen niedrigen Wert (Tₘᵢₙ_FLS; T'ₘᵢₙ_FLS) und vor einer Gleichgewichtsphase (ϕ₂) der Temperatur (T_FL_{S}) des für die Sonde (2) bestimmten Stroms auf einem Wert höher als der niedrige Wert zu steuern.

25. System nach dem vorhergehenden Anspruch, **dadurch gekennzeichnet, dass** es eine Vorrichtung zur Kontrolle der Temperatur des ersten Stroms nach einem der Ansprüche 20 bis 22 enthält, und dass das Steuermodul eingerichtet ist, um die Herstellung eines Spektrums durch die Sonde (2) zu steuern, wenn die Temperatur des ersten Stroms während der Übergangsphase (ϕ₁) vorübergehend stabil (T'_{min_}FLS) ist.

## Claims

1. Method for controlling the temperature of a first flow of fluid (FL_{S}) intended to be used by a nuclear magnetic resonance analysis probe (2) to spin a sample holder (20) of the probe (2) at a given rotational frequency dependent on a flow rate of the first flow, comprising an operation (E1-E3) of circulating the first flow, during which operation the said first flow (FL_{S}) passes through a heat exchanger (30) at a first flow rate, **characterized in that** it comprises an initial cooling step (E0) during which the temperature (T_ECH) of the heat exchanger (30) is lowered and, at the same time, the flow rate of the said first flow (FL_{S}) is set to an initial flow rate which is lower than the first flow rate and, following the said initial cooling step (E0), the operation of circulating the first flow (FL_{S}) at the first flow rate is initiated (E1).

2. Method according to the preceding claim, **characterized in that** the initial flow rate of the first flow is set to zero.

3. Method according to Claim 1, **characterized in that**, with the first flow (FL_{S}) circulating through a circuit (4), the initial flow rate of the said first flow (FLs) is set to a value set such that the pressure inside the said circuit is greater than or equal to the pressure outside the said circuit.

4. Method according to one of the preceding claims, **characterized in that** during the initial cooling step, the temperature of the heat exchanger (30) is lowered to a low value which is lower than an equilibrium value Tfh_ECH reached after the first flow circulation at the first flow rate.

5. Method according to one of the preceding claims, **characterized in that** during the initial step (E0), a second flow (FL_{C}) of a coolant is circulated through the heat exchanger (30) at a flow rate (Dₘₐₓ_FL_{C}) such as a maximum flow rate of the said cooling flow (FL_{C}).

6. Method according to the preceding claim, **characterized in that** during the initial step (E0), the temperature (T_ECH) of the exchanger (30) is lowered to a low value (Tₘᵢₙ_FL_{S}) which corresponds to a minimum equilibrium temperature of the heat exchanger (30) through which the second cooling flow (FL_{C}) passes.

7. Method according to one of the preceding claims, **characterized in that** following the triggering of the operation of circulation of the first flow, with the first flow rate (D_FL_{S}) of the said first flow set to a desired value, the evolution of the temperature (T_FL_{S}) of the first flow (FL_{S}) with respect to time comprises in succession a first phase (ϕ₀) of lowering the said temperature, a transient second phase (ϕ₁) comprising a raising of the said temperature to an equilibrium value, and an equilibrium third phase (ϕ₂) in which the said temperature is stable and equal to the equilibrium value, the said transient phase being of a duration that is set such as to allow the probe (2) to create an NMR spectrum of a sample.

8. Method according to the preceding claim, **characterized in that** the first flow (FL_{S}), circulating at the first flow rate, passes through a heating module (31) and **in that** the heating power of the said module (31) is raised to a high value then decreased so that the temperature (T_FL_{S}) of the first flow (FL_{S}) is temporarily stable for part of the transient phase (ϕ₁), notably for a first part of the transient phase.

9. Method according to the preceding claim, **characterized in that** the circulating first flow (FL_{S}) passes through the heating module (31) downstream of the heat exchanger in the direction in which the said flow (FL_{S}) circulates.

10. Method according to one of Claims 8 and 9, **characterized in that** the heating module (31) comprises an electrical resistance.

11. Method according to the preceding claim, **characterized in that** the said first flow rate of the first flow is set to a value corresponding to a frequency greater than or equal to a limit rotational frequency, notably greater than or equal to 10kHz.

12. Method of operating a nuclear magnetic resonance analysis system (1) comprising a probe (2) for the nuclear magnetic resonance analysis of a sample, a circuit (4) for circulating a first flow of fluid (FL_{S}) intended to be used by the said probe (2) and a device (3) for controlling the temperature of the said first flow (FL_{S}) comprising a heat exchanger (30), **characterized in that** the temperature of the first flow (FL_{S}) is controlled by the said control device (3) by implementing the steps of the control method according to one of Claims 1 to 11.

13. Method according to the preceding claim, **characterized in that**, with the temperature of the first flow controlled by the control method according to Claim 7, the probe (2) creates an NMR spectrum of a sample during the said transient phase (ϕ₁).

14. Method according to one of Claims 12 and 13, **characterized in that** with the temperature of the first flow (FL_{S}) controlled by the control method according to Claim 8, the probe (2) creates an NMR spectrum of a sample when the temperature (T_FL_{S}) of the first flow (FL_{S}) is temporarily stable during part of the transient phase (ϕ₁).

15. Device for controlling the temperature of a first flow of a fluid intended to be used by a nuclear magnetic resonance analysis probe (2) to spin a sample holder (20) of the probe (2) at a given rotational frequency dependent on a flow rate of the first flow, incorporating at least one heat exchanger (30) through which the first flow (FL_{S}) is intended to circulate at a first flow rate, **characterized in that** it comprises a command module designed to command an initial drop in the temperature (T_ECH) of the heat exchanger (30) and at the same time set the flow rate of the first flow to an initial flow rate lower than the first flow rate, then initiate circulation of the first flow (FLs) through the exchanger (30) at the first flow rate.

16. Device according to Claim 15, **characterized in that** the command module is designed to set the initial flow rate to zero.

17. Device according to Claim 15, **characterized in that**, with the first flow (FL_{S}) circulating through a circuit (4), the command module is designed to set the initial flow rate of the said first flow (FLs) to a value that is set in such a way that the pressure inside the said circuit is greater than or equal to the pressure outside the said circuit.

18. Device according to one of Claims 15 to 17, **characterized in that** the heat exchanger (30) is designed to have passing through it a second flow (FL_{C}) of a coolant and **in that** the command module is designed to initially command the cooling second flow (FL_{C}) to circulate at a flow rate such as a maximum flow rate (Dₘₐₓ_FL_{C}) of the said cooling flow (FL_{C}), so as to obtain the initial drop in temperature of the exchanger (30).

19. Device according to the preceding claim, **characterized in that** the command module is designed to command an initial drop in the temperature of the exchanger (30) down to a low value (Tₘᵢₙ_ECH) which corresponds to a minimum equilibrium temperature of the heat exchanger (30) through which the second flow (FL_{C}) passes, before initiating the circulation of the first flow (FL_{S}) at the first flow rate.

20. Device according to one of Claims 15 to 19, **characterized in that** it comprises a heating module (31) intended to supply a thermal power to the first flow (FL_{S}) and **in that** the command module is designed to operate the heating module (31) in such a way that the thermal power provided is at a maximum after the initiation of the circulation of the first flow (FL_{S}) at the first flow rate and then decreases in a suitable way so that the temperature (T_FL_{S}) of the first flow (FL_{S}) is temporarily stable.

21. Device according to the preceding claim, **characterized in that** the heating module (31) is positioned downstream of the heat exchanger (30) in the direction of circulation of the first flow (FL_{S}).

22. Device according to one of Claims 20 and 21, **characterized in that** the heating module (31) comprises an electrical resistance.

23. Nuclear magnetic resonance analysis system comprising a probe (2) for the nuclear magnetic resonance analysis of a sample, a circuit (4) for the circulation of a first flow of fluid FL_{S}) intended to be used by the said probe (2) to spin a sample holder (20) of the probe (2) at a given rotational frequency dependent on a flow rate of the first flow and a device for controlling the temperature of the first flow according to one of Claims 15 to 22.

24. System according to the preceding claim, **characterized in that** it comprises a command module designed to command the creation of a spectrum by the probe (2) after the circulation of the first flow at the first flow rate has been initiated, during a transient phase (ϕ₁) subsequent to an initial drop in the temperature (T_FL_{S}) of the first flow (FL_{S}) to a low value (Tₘᵢₙ_FL_{S}; T'ₘᵢₙ_FL_{S}) and prior to a phase (ϕ₂) of equilibrium of the temperature (T_FLs) of the flow intended for the probe (2) at a value higher than the said low value.

25. System according to the preceding claim, **characterized in that** it comprises a device for controlling the temperature of the first flow according to one of Claims 20 to 22 and **in that** the command module is designed to command the creation of a spectrum by the probe (2) when the temperature of the first flow is temporarily stable (T'ₘᵢₙ_FL_{S}) during the said transient phase (ϕ₁).
